# EUROPEAN PATENT SPECIFICATION

(11) **EP 4 332 676 B1**
(45) Date of publication and mention of the grant of the patent: **29.01.2025**
(21) Application number: 23193326.8
(22) Date of filing: 24.08.2023
(51) Int. Cl.: G03F 1/38, G03F 1/24

(54) **REFLECTIVE MASK BLANK AND METHOD FOR MANUFACTURING REFLECTIVE MASK**
REFLEKTIERENDER MASKENROHLING UND VERFAHREN ZUR HERSTELLUNG EINER REFLEKTIERENDEN MASKE
ÉBAUCHE DE MASQUE RÉFLÉCHISSANT ET PROCÉDÉ DE FABRICATION DE MASQUE RÉFLÉCHISSANT

(30) Priority: 01.09.2022 JP 2022139059
(43) Date of publication of application: 06.03.2024
(73) Proprietor: SHIN-ETSU CHEMICAL CO., LTD., Tokyo 1000005 (JP)
(72) Inventor: KOSAKA, Takuro, Niigata, 942-8601 (JP); OGOSE, Taiga, Niigata, 942-8601 (JP)
(74) Representative: Hindles Limited

(56) References cited:
- US-A1- 2018 356 719
- US-A1- 2020 192 213
- US-A1- 2022 187 699

## Description

### Technical Field

The present invention relates to a reflective mask blank as a material of a reflective mask used for manufacturing a semiconductor device such as an LSI device, and a method for manufacturing a reflective mask using the reflective mask blank.

### Background Art

In a process of manufacturing a semiconductor device, a photolithography technique of irradiating a transfer mask with exposure light and transferring a circuit pattern formed on the mask onto a semiconductor substrate (semiconductor wafer) via a reduction projection optical system is repeatedly used. In the related art, a wavelength of exposure light is mainly 193 nm obtained by using argon fluoride (ArF) excimer laser light, and a pattern having dimensions smaller than an exposure wavelength has been finally formed by employing a process called multi-patterning in which an exposure process and a processing process are combined a plurality of times.

However, since there is a demand for formation of even finer patterns due to continuous miniaturization of device patterns, an extreme ultraviolet (EUV) lithography technique using EUV light having a wavelength shorter than that of ArF excimer laser light as exposure light has been developed. The EUV light is, for example, light having a wavelength of about 10 to 20 nm, more specifically, light having a wavelength of about 13.5 nm. This EUV light has extremely low transmittance through a substance, and a transmissive projection optical system or mask of the related art cannot be used, so that a reflective optical element is used. Therefore, a reflective mask is also used as a mask for pattern transfer. The reflective mask generally includes a multilayer reflective film that is formed on a substrate and reflects EUV light and an absorber film that absorbs EUV light is formed in a pattern on the multilayer reflective film. On the other hand, a mask blank in a state before patterning is performed in the absorber film (also including a state in which a resist film is formed) is called a reflective mask blank, and the reflective mask blank is used as a material of the reflective mask.

The reflective mask blank generally has a basic structure including a substrate having low thermal expansion, a multilayer reflective film that reflects EUV light and is formed on one of two main surfaces of the substrate, and an absorber film that absorbs EUV light and is formed on the multilayer reflective film. As the multilayer reflective film, a multilayer reflective film that obtains a reflectance suitable for EUV light by alternately laminating a molybdenum (Mo) layer and a silicon (Si) layer is usually used. Moreover, as a protective film for protecting the multilayer reflective film, a ruthenium (Ru) film is formed on the multilayer reflective film. In addition, as the absorber film, tantalum (Ta) or the like having a relatively high value of an extinction coefficient with respect to EUV light is used (JP 2002-246299 A or the like). On the other hand, a back conductive film is formed on the other main surface of the substrate. As the back conductive film, a metal nitride film has been proposed for electrostatic chucking, and examples thereof mainly include a nitride film of chromium (Cr), tantalum (Ta), molybdenum (Mo), or silicon (Si).

The prior art document US2020192213 A1 discloses all the features of the preamble of claim 1.

### SUMMARY OF INVENTION

### PROBLEM TO BE SOLVED BY INVENTION

A back conductive film is required not only to have low sheet resistance and low surface roughness for electrostatic chucking, but also to reduce the occurrence of defects at the time of attaching and detaching a mask by the exposure device. When tantalum (Ta) is used for the back conductive film, a small amount of nitrogen may be added to the film in order to decrease the sheet resistance and decrease the surface roughness. In addition, it is effective to nitride the film by adding nitrogen in order to reduce the occurrence of defects at the time of attaching and detaching the mask by the exposure apparatus. However, regarding a film having a low nitriding degree and having a large amount of metal bonds of tantalum (Ta), when there is so-called rubbing such as application of a force to the substrate in a state where the film is in contact with another material, a scratch mark is likely to appear, and a defect may occur at the time of attachment and detachment in an electrostatic chuck stage in the exposure machine. On the other hand, in a case where a large amount of nitrogen is added to the film, a scratch mark is less likely to appear; however, the sheet resistance of the film increases, so that an electrostatic chuck cannot be formed, and further, the film stress due to crystal growth of tantalum nitride tends to increase, and an increase in film surface roughness or the like also occurs, so that a likelihood of the occurrence of defects increases.

The present invention has been made to solve the above problems, and objects of the present invention are to provide a reflective mask blank including a back conductive film in which hardly any defects occur at the time of attachment/detachment in an electrostatic chuck stage while maintaining conductivity and surface roughness required for the back conductive film, and a method for manufacturing a reflective mask using the reflective mask blank.

### MEANS FOR SOLVING PROBLEM

As a result of comprehensive studies to solve the above problems, the inventors of the present application have found that a back conductive film has a layer that contains tantalum (Ta), silicon (Si), and nitrogen (N), has a nitrogen content of 18 atom% or more and less than 35 atom%, and has a CSi/(CTa + CSi) of 3% or more and less than 50% when a silicon content in atom% is denoted by CSi and a tantalum content in atom% is denoted by CTa, and thereby the back conductive film tends to be microcrystalline or amorphous, and an increase in film stress, surface roughness, and the like can be suppressed. When the silicon (Si) content is too large, the sheet resistance at the time of nitriding the film tends to be high, but the sheet resistance can be weakened by setting the content to the above range. In addition, the nitrogen content set to the above range can reduce an abundance proportion of the metal bonds of tantalum, the film has a film quality to the extent that a scratch mark is less likely to occur, and a risk of the occurrence at the time of chuck stage attachment and detachment can be reduced, so that the present invention has been completed.

Hence, the present invention provides the following reflective mask blank and method for manufacturing a reflective mask.

### [Concept 1]

A reflective mask blank according to the present invention comprises:
a substrate;
a multilayer reflective film that is provided on one surface of the substrate and reflects at least EUV light; and
a back conductive film that is provided on the other surface of the substrate,
wherein the back conductive film has a layer which has a film thickness of 50 nm or more and less than 80 nm, contains tantalum (Ta), silicon (Si) and nitrogen (N), has a nitrogen content of 18 atom% or more and less than 35 atom%, and has a CSi/(CTa + CSi) of 3% or more and less than 50% when a silicon content in atom% is denoted by CSi and a tantalum content in atom% is denoted by CTa.

### [Concept 2]

In the reflective mask blank according to concept 1,
the back conductive film may have
a first layer which has a film thickness of 50 nm or more and less than 80 nm, contains tantalum (Ta), silicon (Si) and nitrogen (N), has a nitrogen content of 18 atom% or more and less than 35 atom%, and has a CSi/(CTa + CSi) of 3% or more and less than 50% when a silicon content in atom% is denoted by CSi and a tantalum content in atom% is denoted by CTa, and
a second layer which has a film thickness of 3 nm or more and less than 10 nm, contains tantalum (Ta), silicon (Si), nitrogen (N) and oxygen (O), and has a total content of nitrogen and oxygen is 40 atom% or more.

### [Concept 3]

In the reflective mask blank according to concept 2,
the first layer may be provided on the other surface of the substrate, and
the second layer may be provided on the other surface of the first layer.

### [Concept 4]

In the reflective mask blank according to concept 1,
the back conductive film may contain only tantalum (Ta), silicon (Si) and nitrogen (N).

### [Concept 5]

In the reflective mask blank according to concept 1 or 4,
the back conductive film may have only the layer which has a film thickness of 50 nm or more and less than 80 nm, contains tantalum (Ta), silicon (Si) and nitrogen (N), has a nitrogen content of 18 atom% or more and less than 35 atom%, and has a CSi/(CTa + CSi) of 3% or more and less than 50% when a silicon content in atom% is denoted by CSi and a tantalum content in atom% is denoted by CTa.

### [Concept 6]

In the reflective mask blank according to concept 2,
the first layer may contain only tantalum (Ta), silicon (Si) and nitrogen (N), and
the second layer may contain only tantalum (Ta), silicon (Si), nitrogen (N) and oxygen (O).

### [Concept 7]

In the reflective mask blank according to concept 2 or 6,
the back conductive film may have only the first layer and the second layer.

### [Concept 8]

In the reflective mask blank according to concept 1 or 2,
the back conductive film may have
sheet resistance of 500 Ω/□ or less, and
a film surface roughness (Sq) of 0.5 nm or less, and
when a change amount (ΔTIR) in warpage after the back conductive film is formed from warpage before the back conductive film is formed is expressed as plus (+) when the change amount is in a concave direction and as minus (-) when the change amount is in a convex direction, with respect to a main surface on the other side of the substrate on which the back conductive film is formed, the ΔTIR, which is an index of film stress when the back conductive film is formed on the substrate, may be -0.4 to -1.2 um.

### [Concept 9]

A method for manufacturing reflective mask according to the present invention uses the reflective mask blank according to concept 1 or 2.

By employing the back conductive film provided in Concept 1 described above, it is possible to provide a reflective mask blank having the back conductive film that has good conductivity and surface smoothness and is resistant to rubbing, so that defects are less likely to occur at the time of attachment and detachment in an electrostatic chuck stage.

### BRIEF DESCRIPTION OF DRAWINGS

FIG. 1 is a cross-sectional view illustrating an example of a reflective mask blank according to an embodiment of the present invention;
FIG. 2 is a cross-sectional view illustrating another example of the reflective mask blank according to an embodiment of the present invention;
FIG. 3 is a cross-sectional view illustrating an aspect in which a hard mask film, a reflectance reduction layer, a protective film, and the like are further provided in the reflective mask blank according to the embodiment of the present invention;
FIG. 4 is a cross-sectional view illustrating an aspect in which an absorber film is patterned in the reflective mask blank according to the embodiment of the present invention; and
FIG. 5 is a cross-sectional view illustrating an aspect including a protective film, a resist film, and the like in the reflective mask blank according to the embodiment of the present invention.

### DETAILED DESCRIPTION

Hereinafter, embodiments of the present invention will be described in more detail.

A reflective mask blank (EUV mask blank) of the embodiment is used as a material of a reflective mask (EUV mask) used in EUV lithography using EUV light as exposure light. The reflective mask blank can be obtained by forming an absorber film on a substrate with a reflective mask blank film, and further forming another film as necessary. A wavelength of the EUV light used for EUV lithography using EUV light as exposure light is 13 to 14 nm, and the EUV light is usually light having a wavelength of about 13.5 nm.

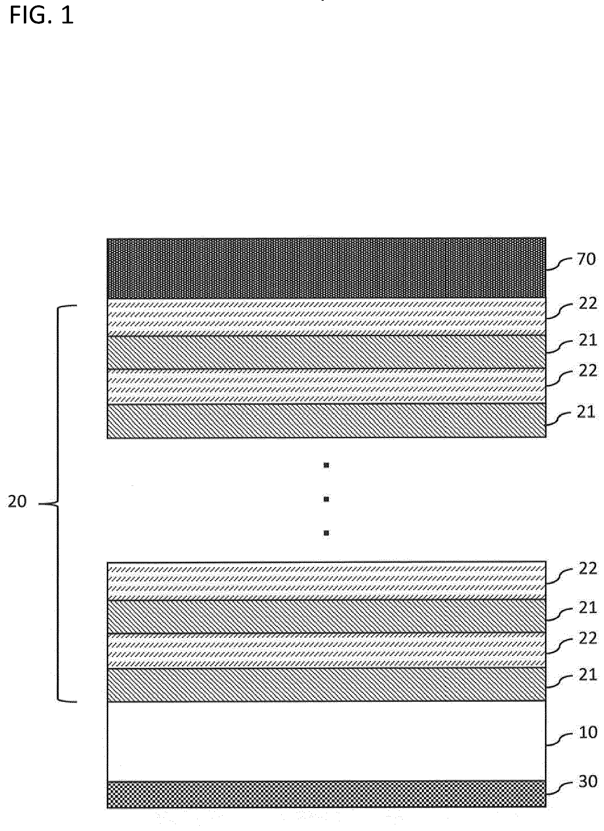

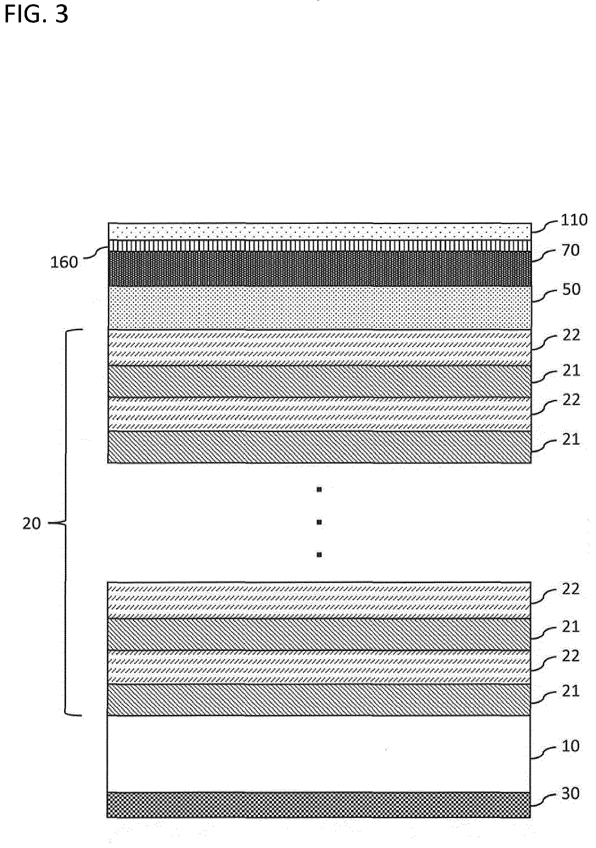

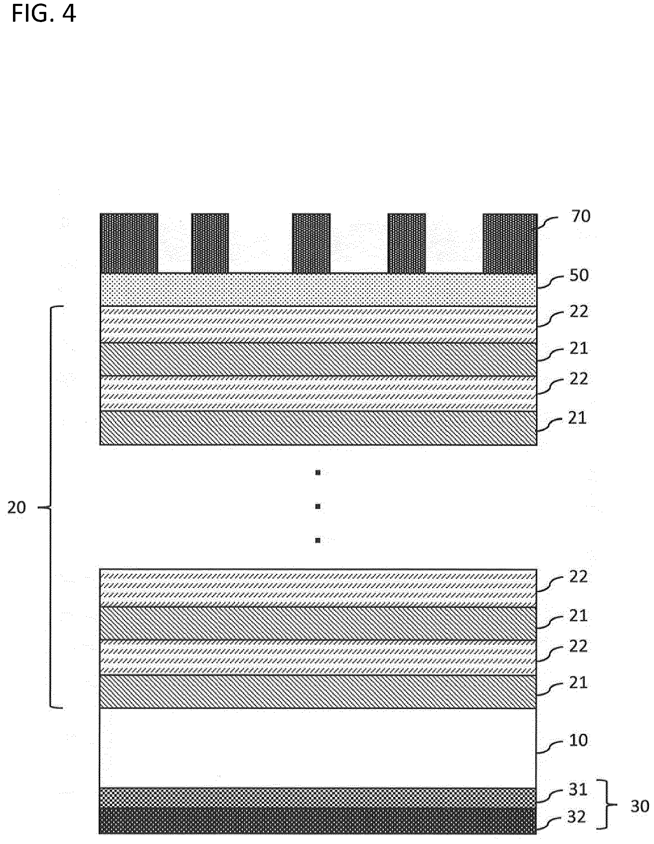

As illustrated in FIG. 1 as an example, the reflective mask blank of the embodiment includes at least a substrate 10, a multilayer reflective film 20 that is formed on one main surface side (surface on the upper side in FIG. 1) of two main surfaces of the substrate 10, preferably in contact with the substrate 10, and reflects EUV light and a back conductive film 30 formed on the other main surface (surface on the lower side in FIG. 1) of the two main surfaces, preferably in contact with the substrate 10. An aspect in which a protective film 50 (see FIGS. 3 to 5) and an absorber film 70 (see FIGS. 1 to 5) are further provided on the multilayer reflective film 20 is also included in the reflective mask blank of the present invention. In addition, a hard mask film 110 (see FIG. 3) may be provided. From the reflective mask blank having the absorber film 70, a reflective mask having an absorber pattern (pattern of the absorber film 70) can be manufactured by patterning the absorber film 70 (see FIG. 4) .

The substrate 10 preferably has low thermal expansion characteristics for EUV light exposure, and for example, is preferably made of a material having a thermal expansion coefficient within a range of ±2 × 10⁻⁸/°C, preferably within a range of ±5 × 10⁻⁹/°C. Examples of the material include titania-doped quartz glass (SiO₂-TiO₂-based glass). In addition, it is preferable to use the substrate 10 having a sufficiently flattened surface, and the surface roughness of a main surface of the substrate 10 is preferably 0.5 nm or less, particularly 0.2 nm or less in terms of a Sq value. The surface roughness can be obtained by polishing the substrate 10 or the like. In the embodiment, a size of the substrate 10 is not particularly limited, and for example, a substrate called a six inch square, 0.25 inch thick 6025 substrate defined in the SEMI standards is suitable, and when the SI unit system is used, the substrate is usually described as a 152 mm square, 6.35 mm thick substrate. In addition, the substrate 10 may have a layer such as a flattened layer on the surface.

The back conductive film 30 is made of tantalum (Ta), silicon (Si), and nitrogen (N), and when a silicon content in atom% is denoted by CSi and a Ta content in atom% is denoted by CTa, CSi/(CTa + CSi) is preferably 3% or more and less than 50%, and more preferably 5% or more and less than 20%. By adding a predetermined amount of silicon (Si), the conductive film tends to have a microcrystalline or amorphous film quality, and an effect of suppressing an increase in film stress, surface roughness, and the like can be obtained. When the silicon (Si) content is too large, sheet resistance when the film is nitrided tends to be high.

The nitrogen content is preferably 18 atom% or more and less than 35 atom% and more preferably 20 atom% or more and less than 25 atom%. Adjustment of the nitrogen content to a predetermined amount to suppress an abundance proportion of the Ta metal bonds enables the film to have a film quality to the extent that a scratch mark is less likely to appear, a risk of the defect occurrence at the time of chuck stage attachment and detachment is reduced, and the sheet resistance is 500 Ω/□ or less when a film thickness is less than 80 nm, so that the film can be satisfactorily adsorbed by an electrostatic chuck.

The nitrogen content of the back conductive film 30 made of tantalum (Ta), silicon (Si), and nitrogen (N) may be determined by using a narrow spectrum of XPS analysis as an index, and at a binding peak of Ta 4f detected near a binding energy of 20 to 24 eV, preferably higher than 22.5 eV and 23.0 eV or lower, more preferably higher than 22.6 eV and 22.9 eV or lower at an apex position of the peak.

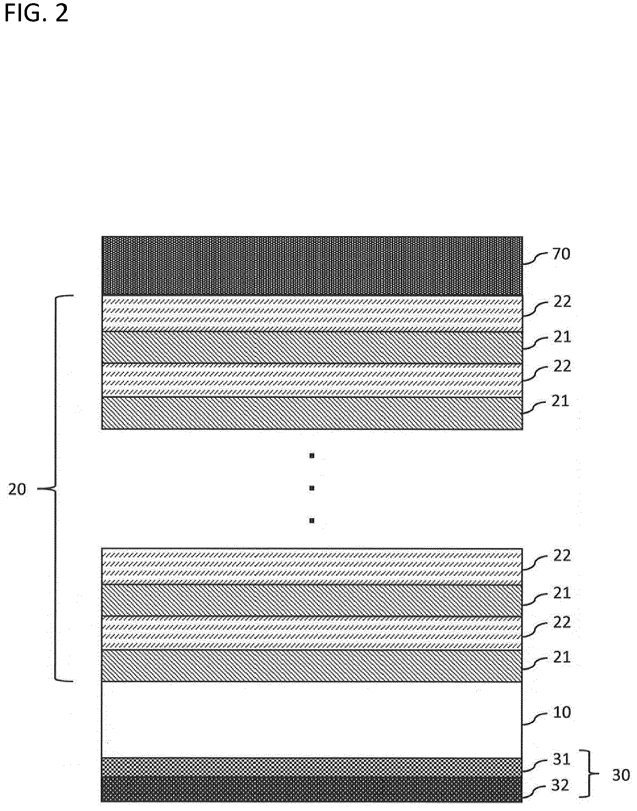

The back conductive film 30 may have a layer (second layer) 32 made of tantalum, silicon, nitrogen, and oxygen in addition to a layer (first layer) 31 made of tantalum, silicon, and nitrogen, and may have a multilayer structure (see FIGS. 2, 4, and 5). An oxynitriding degree of the second layer 32 made of tantalum, silicon, nitrogen and oxygen is preferably higher than that of the first layer 31 made of tantalum, silicon and nitrogen. In addition, the second layer 32 is preferably on a surface layer of the back conductive film 30 on a side (lower side in FIG. 2) separated from the substrate 10. In this case, the first layer 31 may be provided on the other surface (surface on the lower side) of the substrate 10, and the second layer 32 may be provided on the other surface (surface on the lower side) of the first layer 31. Even in the case of the multilayer structure, an entire thickness of the back conductive film 30 is preferably 40 to 100 nm, and more preferably 60 to 80 nm. In addition, a film thickness of the second layer 32 is preferably 20 nm or less, more preferably 10 nm or less.

In the present application, that the back conductive film 30 or the first layer 31 contains only tantalum (Ta), silicon (Si), and nitrogen (N) means that the back conductive film 30 contains tantalum (Ta), silicon (Si), nitrogen (N), and unavoidable impurities. In addition, that the second layer 32 contains only tantalum (Ta), silicon (Si), nitrogen (N), and oxygen (O) means that the second layer 32 contains tantalum (Ta), silicon (Si), nitrogen (N), oxygen (O), and unavoidable impurities.

The film stress of the back conductive film 30 is preferably about the same as the film stress of a surface on which the back conductive film 30 and the multilayer reflective film 20 are formed. On a main surface on which a film is formed, a change amount ΔTIR in a surface shape (warpage) of the substrate 10 after the film is formed from a surface shape before the film is formed can be used as an index. In the present application, ΔTIR is expressed as plus (+) in a case where the change in the substrate shape after the film is formed is a change in a concave direction and as minus (-) in a case where the change is a change in the convex direction with respect to a substrate shape before the film is formed on the surface on which a target film is formed. That is, when the film has tensile stress, the change amount is expressed as plus (+), and when the film has compressive stress, the change amount is expressed as minus (-). Regarding the warpage, warpage having a side within a range of a square having a size of 142 mm can be applied, the side being centered on the center of the main surface of the substrate 10. Here, the change amount (ΔTIR) in warpage is expressed as plus (+) in a case where a change in warpage after the film is formed is a change in the concave direction, and is expressed as minus (-) in a case where the change in warpage is a change in the convex direction, with respect to the warpage before the film is formed with reference to the main surface on which the back conductive film 30 is formed. That is, when the film has tensile stress, the change amount is expressed as plus, and when the film has compressive stress, the change amount is expressed as minus. The ΔTIR is preferably -0.4 um to -1.2 um, and more preferably -0.4 um to -1.0 um.

In addition to the above characteristics, the back conductive film 30 also needs to be less likely to produce defects at the time of attachment and detachment of an electrostatic chuck plate. Examples of the index indicating the likelihood of the occurrence of defects at the time of attachment and detachment include a nano-scratch test using a diamond terminal, a method of observing a state of a scraped surface by rubbing a file-like material such as steel wool against the surface of the film, a method of checking a film peeling state by bonding and peeling a tape on and off a cross-hatch with a scratch mark.

In order to make defects less likely to occur at the time of attachment and detachment of the electrostatic chuck plate, the back conductive film 30 is preferably made of tantalum, silicon, and nitrogen, and further silicon and nitrogen are preferably adjusted to predetermined amounts. When the silicon content in atom% is denoted by CSi and the tantalum content in atom% is denoted by CTa, CSi/(CTa + CSi) is preferably 3% or more and less than 50%, and more preferably 5% or more and less than 20%. By adding a predetermined amount of Si, the conductive film tends to have a microcrystalline or amorphous film quality, and an effect of suppressing an increase in film stress, surface roughness, and the like is obtained. When the silicon content is too large, sheet resistance when the film is nitrided tends to increase.

The warpage of the reflective mask blank varies depending on a composition and physical properties of the film. For example, when the size of the substrate 10 is 152 mm square in the main surface and 6.35 mm in thickness (when the substrate 10 is the 6025 substrate), the substrate 10 with a film for a reflective mask blank has the change amount (ΔTIR) between (1) warpage of one main surface (main surface on the side where the multilayer reflective film 20 or the multilayer reflective film 20 and the protective film 50 are formed) before the multilayer reflective film 20 or the multilayer reflective film 20 and the protective film 50, and the back conductive film 30 are formed on the substrate 10 and (2) warpage of the one main surface (main surface on the side where the multilayer reflective film 20 or the multilayer reflective film 20 and the protective film 50 are formed) in a state in which the multilayer reflective film 20 or the multilayer reflective film 20 and the protective film 50, and the back conductive film 30 are formed on the substrate 10, and the change amount (ΔTIR) is preferably in the range of -0.3 to + 0.3 um. Therefore, it is preferable that an absolute value of the change amount (ΔTIR) in warpage of the substrate 10 before and after forming only the multilayer reflective film 20 or the multilayer reflective film 20 and the protective film 50 on the substrate 10 be substantially equal to an absolute value of the change amount (ΔTIR) in warpage of the substrate 10 before and after forming only the back conductive film 30 on the substrate 10. Here, regarding the warpage, warpage having a side within a range of a square having a size of 142 mm can be applied, the side being centered on the center of the main surface of the substrate 10. Further, the change amount (ΔTIR) in warpage is expressed as plus (+) in a case where the change in warpage is a change in the concave direction and is expressed as minus (-) in a case where the change in warpage is a change in the convex direction, with respect to the warpage before the film is formed with reference to the main surface on which the multilayer reflective film 20 or the multilayer reflective film 20 and the protective film 50 are formed.

The reflective mask blank is usually subjected to heat treatment in advance in consideration of the thermal history in the process of processing the reflective mask. In general, since the reflectance of the multilayer reflective film 20 decreases as a heat treatment temperature increases, the heat treatment temperature is preferably 150°C or lower. Therefore, the substrate with a film for a reflective mask blank has the change amount (ΔTIR) between (1) the warpage of one main surface (main surface on the side where the multilayer reflective film 20 or the multilayer reflective film 20 and the protective film 50 are formed) before the multilayer reflective film 20 or the multilayer reflective film 20 and the protective film 50, and the back conductive film 30 are formed on the substrate 10 and (2) the warpage of the one main surface (main surface on the side where the multilayer reflective film 20 or the multilayer reflective film 20 and the protective film 50 are formed) in a state in which the multilayer reflective film 20 or the multilayer reflective film 20 and the protective film 50, and the back conductive film 30 are formed on the substrate 10, and the heat treatment is performed at 150°C for ten minutes, and the change amount (ΔTIR) is preferably in the range of -0.3 to +0.3 um.

Since the back conductive film 30 is a film used for the exposure device to electrostatically chuck the reflective mask, the electrostatic chucking can be performed when the sheet resistance (RS) is 500 Ω/□ or lower, more preferably 250 Ω/□ or lower, and still more preferably 100 Ω/□ or lower.

From the viewpoint of suppressing generation of particles at the time of attachment and detachment by electrostatic chucking, the surface roughness Sq (root mean square height (ISO 25178)) of the back conductive film 30 is preferably lower, and is preferably 0.5 nm or less, and particularly preferably 0.3 nm or less. As a measurement method, for example, measurement may be performed in a 1 um square using an atomic force microscope (AFM). The high surface roughness is not preferable in that a possibility of the occurrence of defects increase.

The back conductive film 30 may be formed before the multilayer reflective film 20 is formed, or may be formed after all of the films on the multilayer reflective film 20 side of the substrate 10 are formed. In addition, after some films are formed on the multilayer reflective film 20 side of the substrate 10, the back conductive film 30 may be formed, and then the remaining films may be formed on the multilayer reflective film 20 side of the substrate 10.

Examples of a method for forming the back conductive film 30 include a sputtering method in which power is supplied to a target, an atmospheric gas is converted into plasma (ionized) with the supplied power, and sputtering is performed, and an ion beam sputtering method in which the target is irradiated with an ion beam. Examples of the sputtering method include a DC sputtering method in which a DC voltage is applied to a target, and an RF sputtering method in which a high-frequency voltage is applied to a target. The sputtering method is a film forming method in which a voltage is applied to a target in a state where a sputtering gas is introduced into a chamber, the gas is ionized, and a sputtering phenomenon by gas ions is used. In particular, a magnetron sputtering method is advantageous in terms of productivity. In addition, the DC sputtering method also includes pulse sputtering in which a negative bias applied to a target is inverted in a short time in order to prevent the target from being charged up.

The back conductive film 30 can be formed, for example, by a sputtering method using a sputtering apparatus to which one or two or more targets can be loaded. Specifically, the back conductive film can be formed using, as the target, a target made of silicon and tantalum, a silicon (Si) target, a tantalum (Ta) target, or the like and using, as the sputtering gas, a rare gas such as a helium (He) gas, an argon (Ar) gas, a krypton (Kr) gas, or a xenon (Xe) gas, a nitrogen-containing gas such as a nitrogen gas (N₂ gas), and further an oxygen-containing gas such as an oxygen gas (O₂ gas), as necessary.

In the back conductive film 30, a desired composition can be obtained by appropriately adjusting power to be applied to the target (and a ratio thereof in a case of using a plurality of kinds of targets), a flow rate of a reactive gas (and a ratio thereof in a case of using a plurality of kinds of reactive gases), and the like.

The multilayer reflective film 20 is a film that reflects EUV light which is exposure light in the reflective mask. The multilayer reflective film 20 is a multilayer film in which a layer of a low refractive index material and a layer of a high refractive index material are alternately laminated. For EUV light having an exposure wavelength of 13 to 14 nm, for example, a Mo/Si cyclic lamination film in which molybdenum (Mo) layers 22 and silicon (Si) layers 21 are alternately laminated for about 40 cycles (40 layers each) to 60 cycles (60 layers each) is used. The film thickness of the multilayer reflective film 20 is usually about 280 to 350 nm. In addition, a SiN layer may be formed between the Mo layer and the Si layer.

Examples of a method for forming the multilayer reflective film 20 include a sputtering method in which power is supplied to a target, an atmospheric gas is converted into plasma (ionized) with the supplied power, and sputtering is performed, and an ion beam sputtering method in which the target is irradiated with an ion beam. As the sputtering method, a magnetron sputtering method is particularly advantageous in terms of productivity. The power applied to the target may be DC or RF, and the DC sputtering method also includes pulse sputtering in which a negative bias applied to the target is inverted in a short time in order to prevent the target from being charged up.

The multilayer reflective film 20 can be formed, for example, by the sputtering method using a sputtering apparatus capable of loading a plurality of targets. Specifically, the multilayer reflective film can be formed using, as the target, a molybdenum (Mo) target for forming a layer containing molybdenum (Mo) or a silicon (Si) target for forming a layer containing silicon (Si) and using, as a sputtering gas, a rare gas such as a helium (He) gas, an argon (Ar) gas, a krypton (Kr) gas, or a xenon (Xe) gas. In addition, sputtering may be reactive sputtering using a reactive gas, and in that case, for example, when a film containing nitrogen (N) is formed, a nitrogen-containing gas such as a nitrogen gas (N₂ gas) may be used together with a rare gas.

In a case where a layer containing a plurality of elements is formed, a desired composition, a physical property such as crystallinity, or the like can be obtained by appropriately adjusting power which is applied to the target (and a ratio thereof in a case of using a plurality of kinds of targets), a flow rate of a reactive gas (and a ratio thereof in a case of using a plurality of kinds of reactive gases), and the like.

The absorber film 70 may be formed on the multilayer reflective film 20. The absorber film 70 is a film that absorbs EUV light which is exposure light and reduces the reflectance of the exposure light, and in the reflective mask, a transfer pattern is formed due to a difference in reflectance between a portion where the absorber film 70 is formed and a portion where the absorber film 70 is not formed. The absorber film 70 may be formed on the multilayer reflective film 20 to be in contact with the multilayer reflective film 20 or may be provided on the multilayer reflective film 20 via the protective film 50 (see FIGS. 3 to 5) to be described below.

A material of the absorber film 70 is not limited as long as the material absorbs EUV light and can be patterned. Examples of the material of the absorber film 70 include a material containing tantalum (Ta) or chromium (Cr). In addition, the material containing tantalum or chromium may contain oxygen (O), nitrogen (N), carbon (C), boron (B), or the like. Examples of the material containing tantalum (Ta) include simple Ta and tantalum compounds such as TaO, TaN, TaON, TaC, TaCN, TaCO, TaCON, TaB, TaOB, TaNB, TaONB, TaCB, TaCNB, TaCOB, and TaCONB. Specific examples of the material containing Cr include simple Cr and chromium compounds such as CrO, CrN, CrON, CrC, CrCN, CrCO, CrCON, CrB, CrOB, CrNB, CrONB, CrCB, CrCNB, CrCOB, and CrCONB.

The absorber film 70 can be formed by sputtering, and the sputtering is preferably magnetron sputtering. Specifically, the absorber film can be formed by sputtering using a metal target such as a chromium (Cr) target or a tantalum (Ta) target, a metal compound target (target containing metal such as Cr and Ta and oxygen (O), nitrogen (N), carbon (C), boron (B), and the like) such as a chromium compound target or a tantalum compound target and using, as a sputtering gas, a rare gas such as a helium (He) gas, an argon (Ar) gas, a krypton (Kr) gas, or a xenon (Xe) gas, or performing reactive sputtering using a reactive gas such as an oxygen-containing gas, a nitrogen-containing gas, or a carbon-containing gas together with a rare gas. A film thickness of the absorber film 70 is not particularly limited and is usually about 30 to 90 nm.

Preferably, the protective film 50 is formed between the multilayer reflective film 20 and the absorber film 70 to be in contact with the multilayer reflective film 20, more preferably to be in contact with both the multilayer reflective film 20 and the absorber film 70 (see FIGS. 3 to 5). The protective film 50 is also called a capping layer and is provided to protect the multilayer reflective film 20 when a pattern is formed on the absorber film 70 on the protective film 50 or when a pattern of the absorber film 70 is modified.

A material of the protective film 50 is preferably a material containing ruthenium (Ru). As the material containing ruthenium (Ru), simple ruthenium (Ru), a compound obtained by adding niobium (Nb) or zirconium (Zr) to ruthenium (Ru), or the like is suitably used. A thickness of the protective film 50 is usually 5 nm or less and particularly preferably 4 nm or less. The lower limit of the thickness of the protective film 50 is usually 2 nm or more.

Similarly to the multilayer reflective film 20, the protective film 50 can be formed by, for example, a sputtering method such as an ion beam sputtering method or a magnetron sputtering method. The protective film 50 can be formed by a sputtering method using, for example, a sputtering apparatus capable of loading one or a plurality of targets. Specifically, the protective film can be formed by sputtering using a ruthenium (Ru) target or a ruthenium (Ru) target to which niobium (Nb), zirconium (Zr), or the like is added, and a target made of one or more elements selected from niobium (Nb) and zirconium (Zr) as necessary, and using, as a sputtering gas, a rare gas such as a helium (He) gas, an argon (Ar) gas, a krypton (Kr) gas, or a xenon (Xe) gas.

In a case where the protective film 50 is made of a compound containing an element other than metal, the protective film can be formed by reactive sputtering using, as a sputtering gas, a reactive gas such as an oxygen-containing gas, a nitrogen-containing gas, or a carbon-containing gas together with a rare gas. In addition, the target may be a compound.

On the side of the absorber film 70 away from the substrate 10, a hard mask film (etching mask film of the absorber film 70, the etching mask film functioning as an etching mask when the absorber film 70 is dry-etched) 110 that is preferably in contact with the absorber film 70 and has an etching characteristic different from that of the absorber film 70 may be provided (see FIG. 3). The hard mask film 110 is a film that functions as an etching mask when the absorber film 70 is dry-etched. After an absorber pattern is formed, the hard mask film 110 may be removed so as not to remain on the reflective mask, for example, to remain as a reflectance reduction layer for reducing the reflectance at a wavelength of light used in inspection such as pattern inspection to be even as a part of the absorber film 70. Examples of the material of the hard mask film 110 include a material containing chromium (Cr). The hard mask film 110 made of a material containing chromium (Cr) is particularly suitable in a case where the absorber film 70 is made of a material containing tantalum (Ta) and not containing chromium (Cr). When the layer (reflectance reduction layer) 160 that mainly fulfills a function of reducing the reflectance at the wavelength of light used in the inspection such as the pattern inspection is formed on the absorber film 70, the hard mask film 110 can be formed on the reflectance reduction layer 160 of the absorber film 70 (see FIG. 3). The hard mask film 110 can be formed by, for example, a magnetron sputtering method. A film thickness of the hard mask film 110 is not particularly limited and is usually about 5 to 20 nm.

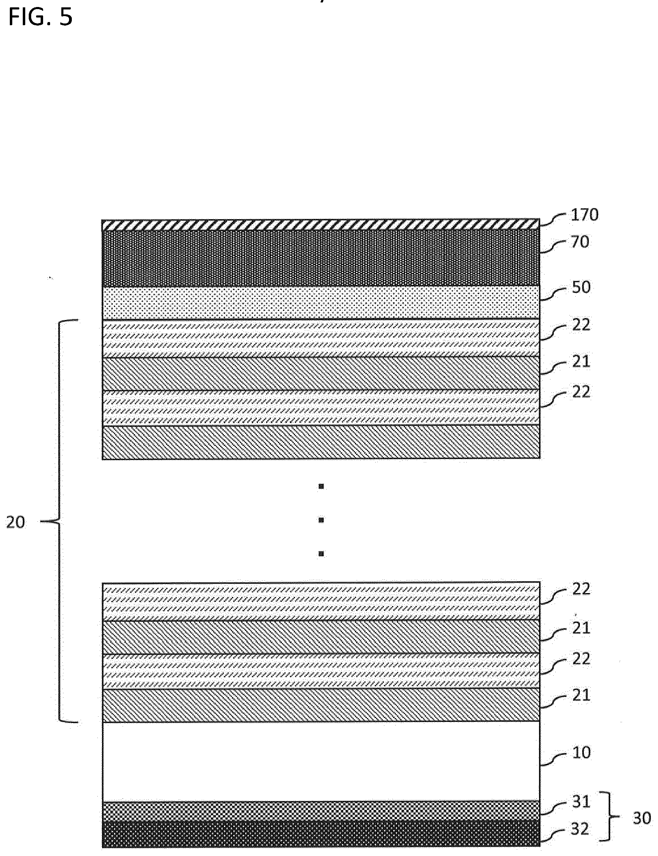

Moreover, the reflective mask blank may have a resist film 170 formed on the side farthest from the substrate 10 (see FIG. 5). The resist film 170 is preferably an electron beam (EB) resist.

### EXAMPLES

Hereinafter, the embodiment will be specifically described with reference to experimental examples, examples, and comparative examples, but the present invention is not limited to the following examples.

### [Example 1]

On the main surface of a 152 mm square, 6.35 mm thick low thermal expansion glass substrate (SiO₂-TiO₂-based glass substrate), the back conductive film 30 was formed by DC pulse magnetron sputtering while the substrate is rotated, by using a tantalum (Ta) target and a silicon (Si) target, and the targets were made to face the main surface of the substrate.

Specifically, the targets were loaded on a sputtering apparatus capable of loading the tantalum (Ta) target and the silicon (Si) target and capable of discharging the targets individually one by one or two or more at the same time, and the substrate was placed.

Then, electric power of 1,550 W was applied to the tantalum (Ta) target and electric power of 250 W was applied to the silicon (Si) target while an argon (Ar) gas (flow rate: 18 sccm) and a nitrogen (N) gas (flow rate: 20 sccm) were caused to flow in the chamber, and thereby the TaSiN back conductive film 30 having a thickness of 70 nm was formed. As a result of measurement of a substrate shape after formation of the back conductive film, ΔTIR was -0.70 um, and a sheet resistance value was 45 Ω/□. Here, ΔTIR is expressed as plus (+) in a case where a change in the surface shape (warpage) after the film is formed is a change in the concave direction with respect to that before the back conductive film 30 is formed on the main surface on which the back conductive film 30 is formed, within a range of a square having a side of 142 mm, the side being centered on the center of the main surface of the substrate, and is expressed as minus (-) in a case where the change is a change in the convex direction (hereinafter, the same plus and minus notations of ΔTIR in the formation of the back conductive film are used in Examples).

Next, as a result of measurement of the surface roughness of the film by an atomic force microscope (AFM, Jupiter XR manufactured by Oxford Instruments plc), the surface roughness Sq was 0.22 nm.

As a result of analysis of a chemical composition of the film by an X-ray photoelectron spectrometer (XPS: K-ALPHA manufactured by Thermo Fisher Scientific Inc.), a nitrogen content was 22 atom%, and CSi/(CTa + CSi) was 10%, where CSi denotes the silicon content in atom%, and CTa denotes the tantalum content in atom%.

Next, in order to evaluate a dust production risk at the time of attachment and detachment at the electrostatic chuck stage of the film, a pattern was formed by a so-called magic lift-off method, and a simple test of a scratch mark was performed.

Specifically, a mark line having a width of about 2 mm and a length of about 1 cm was drawn on a quartz substrate with an oil-based marker pen in a central portion of the substrate in advance, and then the quartz substrate was conveyed into a chamber, and the back conductive film 30 having a TaSiN composition and a thickness of 70 nm was formed under the same conditions as described above. Thereafter, a cotton swab immersed in ethanol was pressed against the mark portion so as not to apply a force to the film surface as much as possible, and the film was caused to peel off together with the marker pen to form a pattern in which a film adhesion site and the substrate were exposed. Next, a cotton swab similarly immersed in ethanol was pressed hard against the mark, and this time, a force was applied to scrub the cotton swab around the pattern site for about 30 seconds, and then the pattern part was observed to check whether a scratch appears, with a single view camera at a magnification of 3.5 times from above the substrate.

Since no scratch mark was observed on the pattern part under the conditions of the example, it is considered that the dust production risk at the time of stage attachment and detachment is low.

### [Example 2]

In the same chamber as that in Example 1, first, electric power of 1,550 W was applied to the tantalum (Ta) target and electric power of 250 W was applied to the silicon (Si) target while an argon (Ar) gas (flow rate: 18 sccm) and a nitrogen gas (flow rate: 25 sccm) were caused to flow in the chamber, and thereby the TaSiN back conductive film 30 having a thickness of 70 nm was formed. As a result of measurement of a substrate shape after formation of the back conductive film, ΔTIR was -1.0 um, and a sheet resistance value was 64 Ω/□.

Next, as a result of measurement of the surface roughness of this film by the AFM, the surface roughness Sq was 0.45 nm.

As a result of measurement of a chemical composition of the film by the XPS analysis, a nitrogen content was 31 atom%, and CSi/(CTa + CSi) was 10%, where CSi denotes the silicon content in atom%, and CTa denotes the tantalum content in atom%. In the same manner as in Example 1, a pattern was formed on a quartz substrate by magic lift off, and a simple test of a scratch mark was performed. As a result, no scratch mark was observed at the pattern part under the conditions of the example. Therefore, it is considered that the dust generation risk at the time of chuck stage attachment and detachment is low.

### [Example 3]

In the same chamber as that in Example 1, first, electric power of 1,550 W was applied to the tantalum (Ta) target and electric power of 250 W was applied to the silicon (Si) target while an argon (Ar) gas (flow rate: 18 sccm) and a nitrogen (N) gas (flow rate: 15 sccm) were caused to flow in the chamber, and thereby the TaSiN back conductive film 30 having a thickness of 70 nm was formed. When a substrate shape was measured after formation of the back conductive film, ΔTIR was -0.75 um, and a sheet resistance value was 37 Ω/□.

Next, the surface roughness of this film was measured by the AFM, and the surface roughness Sq was 0.21 nm.

When a chemical composition of the film was analyzed by the XPS analysis, the nitrogen content was 18 atom%, and CSi/(CTa + CSi) was 10%, where CSi denotes the silicon content in atom%, and CTa denotes the tantalum content in atom%. In the same manner as in Example 1, a pattern was formed on a quartz substrate by magic lift off, and a simple test of a scratch mark was performed. As a result, a slight scratch mark was observed at the pattern part; however, it is considered that the dust production risk at the time of chuck stage attachment and detachment is low.

### [Example 4]

In the same chamber as that in Example 1, first, electric power of 1,050 W was applied to the tantalum (Ta) target and electric power of 750 W was applied to the silicon (Si) target while an argon (Ar) gas (flow rate: 18 sccm) and a nitrogen (N) gas (flow rate: 20 sccm) were caused to flow in the chamber, and thereby the TaSiN back conductive film 30 having a thickness of 70 nm was formed. When a substrate shape was measured after formation of the back conductive film, ΔTIR was -0.49 um, and the sheet resistance value was 71 Ω/□.

Next, the surface roughness of this film was measured by the AFM, and the surface roughness Sq was 0.22 nm.

When a chemical composition of the film was analyzed by the XPS analysis, the nitrogen content was 25 atom%, and CSi/(CTa + CSi) was 42%, where CSi denotes the silicon content in atom%, and CTa denotes the tantalum content in atom%. In the same manner as in Example 1, a pattern was formed on a quartz substrate by magic lift off, and a simple test of a scratch mark was performed. As a result, no scratch mark was observed at the pattern part under the conditions of the example. Therefore, it is considered that the dust generation risk at the time of chuck stage attachment and detachment is low.

### [Example 5]

In the same chamber as that in Example 1, first, electric power of 1,550 W was applied to the tantalum (Ta) target and electric power of 250 W was applied to the silicon (Si) target while an argon (Ar) gas (flow rate: 18 sccm) and a nitrogen (N) gas (flow rate: 20 sccm) were caused to flow in the chamber, and thereby the TaSiN layer (first layer 31) having a thickness of 67 nm was formed.

Subsequently, electric power of 1,550 W was applied to the tantalum (Ta) target and electric power of 250 W was applied to the silicon (Si) target while an argon (Ar) gas (flow rate: 18 sccm), a nitrogen (N) gas (flow rate: 20 sccm), and an oxygen (O) gas (flow rate: 20 sccm) were caused to flow in the same chamber, and thereby the TaSiON layer (second layer 32) having a thickness of 3 nm was laminated to form the multilayer back conductive film 30.

Next, the surface roughness of this film was measured by the AFM, and the surface roughness Sq was 0.21 nm.

As a result of measurement of a chemical composition of the film by the XPS analysis, the nitrogen content of the TaSiN (first layer 31) was 22 atom%, CSi/(CTa + CSi) was 10%, a total content of nitrogen and oxygen of the TaSiON layer (second layer 32) was 53 atom%, and CSi/(CTa + CSi) was 15%.

In the same manner as in Example 1, a pattern was formed on a quartz substrate by magic lift off, and a simple test of a scratch mark was performed. As a result, no scratch mark was observed at the pattern part under the conditions of the example. The TaSiON layer of a surface layer has a film quality that is more likely to be microcrystallized and form an amorphous structure than the TaSiN layer, and it is considered that the dust production risk at the time of chuck stage attachment and detachment is lower.

### [Comparative Example 1]

In the same chamber as that in Example 1, first, electric power of 1,550 W was applied to the tantalum (Ta) target and electric power of 250 W was applied to the silicon (Si) target while an argon (Ar) gas (flow rate: 18 sccm) and a nitrogen (N) gas (flow rate: 12.5 sccm) were caused to flow in the chamber, and thereby the TaSiN back conductive film having a thickness of 70 nm was formed. As a result of measurement of a substrate shape after formation of the back conductive film, ΔTIR was -0.74 um, and a sheet resistance value was 36 Ω/□.

Next, as a result of measurement of the surface roughness of this film by the AFM, the surface roughness was 0.20 nm.

As a result of measurement of a chemical composition of the film by the XPS analysis, a nitrogen content was 17 atom%, and CSi/(CTa + CSi) was 10%, where CSi denotes the silicon content in atom%, and CTa denotes the tantalum content in atom%.

In the same manner as in Example 1, a pattern was formed on a quartz substrate by magic lift off, and a simple test of a scratch mark was performed. As a result, a scratch mark was observed at the pattern part under the conditions of the example, and peeling also occurs at a rubbed position. Hence, it is considered that the dust production risk at the time of electrostatic chuck stage attachment and detachment is high.

### [Comparative Example 2]

In the same chamber as that in Example 1, first, electric power of 1,550 W was applied to the tantalum (Ta) target and electric power of 250 W was applied to the silicon (Si) target while an argon (Ar) gas (flow rate: 18 sccm) and a nitrogen (N) gas (flow rate: 30 sccm) were caused to flow in the chamber, and thereby the TaSiN back conductive film having a thickness of 70 nm was formed. As a result of measurement of a substrate shape after formation of the back conductive film, ΔTIR was -0.73 um, and a sheet resistance value was 848 Ω/□.

Next, as a result of measurement of the surface roughness of this film by the AFM, the surface roughness Sq was 1.1 nm.

As a result of measurement of a chemical composition of the film by the XPS analysis, a nitrogen content was 37 atom%, and CSi/(CTa + CSi) was 10%, where CSi denotes the silicon content in atom%, and CTa denotes the tantalum content in atom%. In the same manner as in Example 1, a pattern was formed on a quartz substrate by magic lift off, and a simple test of a scratch mark was performed. As a result, no scratch mark was observed at the pattern part under the conditions of the example. However, as described above, in addition to the high sheet resistance of 848 Ω/□, the surface roughness was also rough, and the dust production risk at the time of electrostatic chuck stage attachment and detachment was high, and thus the film was unsuitable as the back conductive film.

### [Comparative Example 3]

In the same chamber as that in Example 1, first, electric power of 800 W was applied to the tantalum (Ta) target and electric power of 1,000 W was applied to the silicon (Si) target while an argon (Ar) gas (flow rate: 18 sccm) and a nitrogen (N) gas (flow rate: 25 sccm) were caused to flow in the chamber, and thereby the TaSiN back conductive film having a thickness of 70 nm was formed. As a result of measurement of a substrate shape after formation of the back conductive film, ΔTIR was -0.61 um, and a sheet resistance value was 520 Ω/□.

Next, the surface roughness of this film was measured by the AFM, and the surface roughness Sq was 0.3 nm. As a result of measurement of a chemical composition of the film by the XPS analysis, a nitrogen content was 30 atom%, and CSi/(CTa + CSi) was 56%, where CSi denotes the silicon content in atom%, and CTa denotes the tantalum content in atom%.

In the same manner as in Example 1, a pattern was formed on a quartz substrate by magic lift off, and a simple test of a scratch mark was performed. As a result, no scratch mark was observed at the pattern part under the conditions of the example. However, the sheet resistance value is as high as 520 Ω/□, and thus this aspect is not preferable from the viewpoint of suitable adsorption by the electrostatic chuck.

### [Comparative Example 4]

In the same chamber as that in Example 1, first, electric power of 1,800 W was applied only to the tantalum (Ta) target while an argon (Ar) gas (flow rate: 18 sccm) and a nitrogen (N) gas (flow rate: 20 sccm) were caused to flow in the chamber, and thereby a TaN back conductive film having a thickness of 70 nm was formed. As a result of measurement of a substrate shape after formation of the back conductive film, ΔTIR was -2.18 um, and a sheet resistance value was 37 Ω/□.

Next, the surface roughness of this film was measured by the AFM, and the surface roughness Sq was 0.3 nm.

As a result of measurement of a composition of this film by the XPS analysis, the nitrogen content was 28 atom%.

In the same manner as in Example 1, a pattern was formed on a quartz substrate by magic lift off, and a simple test of a scratch mark was performed. As a result, no scratch mark was observed at the pattern part under the conditions of the example; however, the film stress was high, and thus the film was not suitable as the back conductive film.

## Claims

1. A reflective mask blank comprising:
a substrate (10);
a multilayer reflective film (20) that is provided on one surface of the substrate and reflects at least EUV light; and
a back conductive film (30) that is provided on the other surface of the substrate,
wherein the back conductive film has a layer which has a film thickness of 50 nm or more and less than 80 nm, contains tantalum (Ta), silicon (Si) and nitrogen (N), **characterized in that** the layer has a nitrogen content of 18 atom% or more and less than 35 atom%, and has a CSi/(CTa + CSi) of 3% or more and less than 50% when a silicon content in atom% is denoted by CSi and a tantalum content in atom% is denoted by CTa.

2. The reflective mask blank according to claim 1,
wherein the back conductive film has
a first layer (31) which has a film thickness of 50 nm or more and less than 80 nm, contains tantalum (Ta), silicon (Si) and nitrogen (N), has a nitrogen content of 18 atom% or more and less than 35 atom%, and has a CSi/(CTa + CSi) of 3% or more and less than 50% when a silicon content in atom% is denoted by CSi and a tantalum content in atom% is denoted by CTa, and
a second layer (32) which has a film thickness of 3 nm or more and less than 10 nm, contains tantalum (Ta), silicon (Si), nitrogen (N) and oxygen (O), and has a total content of nitrogen and oxygen is 40 atom% or more.

3. The reflective mask blank according to claim 2,
wherein the first layer is provided on the other surface of the substrate, and
wherein the second layer is provided on the other surface of the first layer.

4. The reflective mask blank according to claim 1,
wherein the back conductive film contains only tantalum (Ta), silicon (Si) and nitrogen (N).

5. The reflective mask blank according to claim 1 or 4,
wherein the back conductive film has only the layer which has a film thickness of 50 nm or more and less than 80 nm, contains tantalum (Ta), silicon (Si) and nitrogen (N), has a nitrogen content of 18 atom% or more and less than 35 atom%, and has a CSi/(CTa + CSi) of 3% or more and less than 50% when a silicon content in atom% is denoted by CSi and a tantalum content in atom% is denoted by CTa.

6. The reflective mask blank according to claim 2,
wherein the first layer contains only tantalum (Ta), silicon (Si) and nitrogen (N), and
wherein the second layer contains only tantalum (Ta), silicon (Si), nitrogen (N) and oxygen (O).

7. The reflective mask blank according to claim 2 or 6,
wherein the back conductive film has only the first layer and the second layer.

8. The reflective mask blank according to claim 1 or 2,
wherein the back conductive film has
sheet resistance of 500 Ω/□ or less, and
a film surface roughness (Sq) of 0.5 nm or less, and wherein, when a change amount (ΔTIR) in warpage after the back conductive film is formed from warpage before the back conductive film is formed is expressed as plus (+) when the change amount is in a concave direction and as minus (-) when the change amount is in a convex direction, with respect to a main surface on the other side of the substrate on which the back conductive film is formed, the ΔTIR, which is an index of film stress when the back conductive film is formed on the substrate, is -0.4 to -1.2 um.

9. A method for manufacturing a reflective mask using the reflective mask blank according to claim 1 or 2.

## Patentansprüche

1. Reflektierender Maskenrohling, umfassend:
ein Substrat (10);
einen mehrschichtigen reflektierenden Film (20), der auf einer Oberfläche des Substrats vorgesehen ist und mindestens EUV-Licht reflektiert; und
einen rückseitigen leitfähigen Film (30), der auf der anderen Oberfläche des Substrats vorgesehen ist,
wobei der rückseitige leitfähige Film eine Schicht aufweist, die eine Filmdicke von 50 nm oder mehr und weniger als 80 nm aufweist, Tantal (Ta), Silizium (Si) und Stickstoff (N) enthält, **dadurch gekennzeichnet, dass** die Schicht einen Stickstoffgehalt von 18 Atom-% oder mehr und weniger als 35 Atom-% aufweist ein CSi/(CTa + CSi) von 3 % oder mehr und weniger als 50 % aufweist, wenn ein Siliziumgehalt in Atom-% mit CSi und ein Tantalgehalt in Atom-% mit CTa bezeichnet wird.

2. Reflektierender Maskenrohling nach Anspruch 1,
wobei der rückseitige leitfähige Film Folgendes aufweist
eine erste Schicht (31),
die eine Filmdicke von 50 nm oder mehr und weniger als 80 nm aufweist, Tantal (Ta), Silizium (Si) und Stickstoff (N) enthält, einen Stickstoffgehalt von 18 Atom-% oder mehr und weniger als 35 Atom-% aufweist und ein CSi/(CTa + CSi) von 3 % oder mehr und weniger als 50 % aufweist, wenn ein Siliziumgehalt in Atom-% mit CSi bezeichnet wird und ein Tantalgehalt in Atom-% mit CTa bezeichnet wird, und
eine zweite Schicht (32),
die eine Filmdicke von 3 nm oder mehr und weniger als 10 nm aufweist, Tantal (Ta), Silizium (Si), Stickstoff (N) und Sauerstoff (O) enthält und einen Gesamtgehalt an Stickstoff und Sauerstoff von 40 Atom-% oder mehr aufweist.

3. Reflektierender Maskenrohling nach Anspruch 2,
wobei die erste Schicht auf der anderen Oberfläche des Substrats vorgesehen ist, und
wobei die zweite Schicht auf der anderen Oberfläche der ersten Schicht vorgesehen ist.

4. Reflektierender Maskenrohling nach Anspruch 1,
wobei der rückseitige leitfähige Film nur Tantal (Ta), Silizium (Si) und Stickstoff (N) enthält.

5. Reflektierender Maskenrohling nach Anspruch 1 oder 4,
wobei der rückseitige leitfähige Film nur die Schicht aufweist, die eine Filmdicke von 50 nm oder mehr und weniger als 80 nm aufweist, Tantal (Ta), Silizium (Si) und Stickstoff (N) enthält, einen Stickstoffgehalt von 18 Atom-% oder mehr und weniger als 35 Atom-% aufweist ein CSi/(CTa + CSi) von 3 % oder mehr und weniger als 50 % aufweist, wenn ein Siliziumgehalt in Atom-% mit Csi bezeichnet wird und ein Tantalgehalt in Atom-% mit CTa bezeichnet wird.

6. Reflektierender Maskenrohling nach Anspruch 2,
wobei die erste Schicht nur Tantal (Ta), Silizium (Si) und Stickstoff (N) enthält, und
wobei die zweite Schicht nur Tantal (Ta), Silizium (Si), Stickstoff (N) und Sauerstoff (O) enthält.

7. Reflektierender Maskenrohling nach Anspruch 2 oder 6,
wobei der rückseitige leitfähige Film nur die erste Schicht und die zweite Schicht aufweist.

8. Reflektierender Maskenrohling nach Anspruch 1 oder 2,
wobei der rückseitige leitfähige Film einen Flächenwiderstand von 500 Ω/□ oder weniger, und
eine Filmoberflächenrauheit (Sq) von 0,5 nm oder weniger aufweist, und
wobei, wenn ein Änderungsbetrag (ΔTIR) der Verformung nach der Bildung des rückseitigen leitfähigen Films gegenüber der Verformung vor der Bildung des rückseitigen leitfähigen Films als Plus (+) ausgedrückt wird, wenn der Änderungsbetrag in einer konkaven Richtung liegt, und als Minus (-), wenn der Änderungsbetrag in einer konvexen Richtung liegt, in Bezug auf eine Hauptoberfläche auf der anderen Seite des Substrats, auf der der rückseitige leitfähige Film gebildet ist, der ΔTIR, der ein Index der Filmspannung ist, wenn der rückseitige leitfähige Film auf dem Substrat gebildet ist, -0,4 bis -1,2 µm beträgt.

9. Verfahren zum Herstellen einer reflektierenden Maske unter Verwendung des reflektierenden Maskenrohlings nach Anspruch 1 oder 2.

## Revendications

1. Ébauche de masque réfléchissant comprenant :
un substrat (10) ;
un film réfléchissant multicouche (20) qui est fourni sur une surface du substrat et reflète au moins la lumière EUV ; et
un film conducteur arrière (30) qui est fourni sur l'autre surface du substrat,
dans laquelle le film conducteur dorsal a une couche qui a une épaisseur de 50 nm ou plus et inférieure à 80 nm, contenant du tantale (Ta), du silicium (Si) et de l'azote (N), **caractérisée en ce que** la couche a une teneur en azote de 18 % ou plus et inférieure à 35 %, et a un CSi/(CTa + CSi) de 3 % ou plus et inférieur à 50 % lorsque la teneur en silicium en atomes est désignée par CSi et que la teneur en tantale en atomes est désignée par CTa.

2. Ébauche de masque réfléchissant selon la revendication 1,
dans laquelle le film conducteur arrière a
une première couche (31)
qui a une épaisseur de film égale ou supérieure à 50 nm et inférieure à 80 nm, contient du tantale (Ta), du silicium (Si) et de l'azote (N), a une teneur en azote égale ou supérieure à 18 % et inférieure à 35 %, et a un rapport CSi/(CTa + CSi) égal ou supérieur à 3 % et inférieur à 50 % lorsque la teneur en silicium en % atomique est désignée par CSi et la teneur en tantale en % atomique est désignée par CTa, et
une seconde couche (32)
qui a une épaisseur de film de 3 nm ou plus et de moins de 10 nm, contient du tantale (Ta), du silicium (Si), de l'azote (N) et de l'oxygène (O), et dont la teneur totale en azote et en oxygène est de 40 % ou plus.

3. Ébauche de masque réfléchissant selon la revendication 2,
dans laquelle la première couche est appliquée sur l'autre surface du substrat, et
dans laquelle la seconde couche est fournie sur l'autre surface de la première couche.

4. Ébauche de masque réfléchissant selon la revendication 1,
dans laquelle le film conducteur arrière ne contient que du tantale (Ta), du silicium (Si) et de l'azote (N).

5. Ébauche de masque réfléchissant selon la revendication 1 ou 4,
dans laquelle le film conducteur dorsal ne comporte que la couche dont l'épaisseur est supérieure ou égale à 50 nm et inférieure à 80 nm, qui contient du tantale (Ta), du silicium (Si) et de l'azote (N), dont la teneur en azote est supérieure ou égale à 18 % et inférieure à 35 %, et dont le rapport CSi/(CTa + CSi) est supérieur ou égal à 3 % et inférieur à 50 % lorsque la teneur en silicium en % atomique est désignée par CSi et la teneur en tantale en % atomique est désignée par CTa.

6. Ébauche de masque réfléchissant selon la revendication 2,
dans laquelle la première couche ne contient que du tantale (Ta), du silicium (Si) et de l'azote (N), et
dans laquelle la seconde couche ne contient que du tantale (Ta), du silicium (Si), de l'azote (N) et de l'oxygène (O).

7. Ébauche de masque réfléchissant selon la revendication 2 ou 6,
dans laquelle le film conducteur arrière n'a que la première et la seconde couche.

8. Ébauche de masque réfléchissant selon la revendication 1 ou 2,
dans laquelle le film conducteur arrière a une résistance de feuille de 500 Ω/□ ou moins, et
une rugosité de surface de film (Sq) de 0,5 nm ou moins, et
dans laquelle, lorsqu'une variation (ΔTIR) du gauchissement après la formation du film conducteur arrière par rapport au gauchissement avant la formation du film conducteur arrière est exprimée comme plus (+), lorsque la variation est dans le sens concave et comme moins (-) lorsque la variation est dans le sens convexe, par rapport à une surface principale de l'autre côté du substrat sur lequel le film conducteur arrière est formé, le ΔTIR, qui est un indice de la contrainte du film lorsque le film conducteur arrière est formé sur le substrat, est compris entre -0,4 et -1,2 um.

9. Procédé de fabrication d'un masque réfléchissant à l'aide de l'ébauche de masque réfléchissant selon la revendication 1 ou 2.
